# DEMANDE DE BREVET EUROPEEN

(11) **EP 2 869 028 A1**
(43) Date de publication de la demande: **06.05.2015**
(21) Numéro de dépôt: 14191189.1
(22) Date de dépôt: 31.10.2014
(51) Int. Cl.: G01D 4/00, G01R 11/56, G01R 21/133

(54) **Procédé de configuration d'un dispositif de lecture et d'enregistrement d'impulsions destiné à effectuer une lecture d'au moins un compteur émettant des impulsions et dispositif associe**

(30) Priorité: 31.10.2013 FR 1360723
(71) Demandeur: Somfy SAS, 74300 Cluses (FR)
(72) Inventeur: Gueurce, Laurent, 74250 Viuz en Sallaz (FR); Devis, Frédéric, 74330 Epagny (FR); Cogne, Pierre-Yves, 74250 Bogève (FR); Jain, Thierry, 74570 Groisy (FR)
(74) Mandataire: Bugnion Genève

(57) **Abrégé**

Un procédé de configuration d'un dispositif de lecture et d'enregistrement d'impulsions (1) destiné à effectuer une lecture d'au moins un compteur (2) émettant des impulsions, ledit dispositif (1) comprenant au moins un capteur de détection d'impulsions (3) et au moins un dispositif de mémorisation de données (4), comprend : une acquisition d'une donnée relative au type de consommation à mesurer par l'intermédiaire d'un capteur de détection d'impulsions (3) connecté à un compteur (2) ; et une mémorisation par un dispositif de mémorisation de données (4) de ladite donnée acquise relative au type de consommation à mesurer par l'intermédiaire dudit capteur de détection d'impulsions (3) connecté audit compteur (2).

## Description

### DOMAINE TECHNIQUE DE L'INVENTION

La présente invention concerne un procédé de configuration d'un dispositif de lecture et d'enregistrement d'impulsions destiné à effectuer une lecture d'au moins un compteur émettant des impulsions, un procédé de commande en fonctionnement d'un dispositif de lecture et d'enregistrement d'impulsions conformément au procédé de configuration du dispositif de lecture et d'enregistrement d'impulsions, un dispositif de lecture et d'enregistrement d'impulsions adapté à mettre en oeuvre le procédé de configuration et le procédé de commande, et une installation comprenant au moins un système consommateur d'énergie et/ou d'eau et le dispositif de lecture et d'enregistrement d'impulsions.

De manière générale, la présente invention concerne le domaine des dispositifs de lecture et d'enregistrement d'impulsions émises par un compteur, les impulsions étant générées ou envoyées par un compteur en fonction de la consommation d'un système consommateur d'énergie, en particulier de gaz, d'électricité, d'énergie thermique et/ou d'eau.

### ETAT DE LA TECHNIQUE ANTERIEURE

Historiquement, les compteurs d'eau ou d'énergie étaient autonomes et non communicants, en ce sens qu'il permettait une lecture locale uniquement des résultats du comptage effectué.

Avec le développement de la télémétrie, certains compteurs sont devenus aptes à communiquer, au sens où, en parallèle avec leur fonction de comptage autonome local, ils sont aptes à délivrer des impulsions électriques correspondant à des incréments de la grandeur comptée de manière à permettre un comptage redondant à distance.

Pour cette fonction de comptage à distance, on connaît déjà des capteurs de détection d'impulsions connectés à des compteurs par une connexion électrique filaire. Un capteur de détection d'impulsions est dédié au comptage du nombre d'impulsions émises par un compteur pour une consommation déterminée, telle que par exemple l'électricité, le gaz, ou l'eau. Le capteur de détection d'impulsions comprend un moyen de sélection, en particulier des commutateurs, où le moyen de sélection peut être déplacé sur l'une des positions prédéterminées d'une valeur de la consommation à mesurer correspondant à une impulsion du compteur.

Cependant, ce capteur de détection d'impulsions présente l'inconvénient de ne pouvoir comptabiliser les impulsions que d'un seul type de consommation à mesurer.

Par conséquent, pour une installation comprenant différents systèmes consommateurs associés à des compteurs différents, où chaque compteur mesure un type de consommation différente, le dispositif de lecture et d'enregistrement d'impulsions comprend un capteur de détection d'impulsions connecté à un compteur et dédié à un type de consommation à mesurer.

De cette manière, le nombre de capteurs de détection d'impulsions distincts à mettre en oeuvre correspond au nombre de types de consommations à mesurer.

Un dispositif de lecture et d'enregistrement d'impulsions comprenant de tels capteurs de détection d'impulsions est complexe à mettre en oeuvre et onéreux, étant donné que chaque type de consommation à mesurer par l'intermédiaire des impulsions émises par des compteurs nécessite une diversité de capteurs de détection d'impulsions, où chaque capteur de détection d'impulsions est destiné à comptabiliser le nombre d'impulsions pour un type de consommation prédéterminé.

En outre, de tels capteurs de détection d'impulsions présentent également l'inconvénient de ne pouvoir régler une impulsion du compteur que sur l'une des positions prédéterminées correspondant à une valeur de la consommation à mesurer.

Par conséquent, les différentes positions prédéterminées pouvant être prises par le moyen de sélection définissent une valeur de la consommation à mesurer pour une impulsion du compteur.

De cette manière, le nombre de valeurs de la consommation à mesurer est limité par le nombre de positions prédéterminées pouvant être prises par le moyen de sélection.

Ainsi, le réglage du capteur de détection d'impulsions à une valeur de la consommation à mesurer correspondant à une impulsion du compteur nécessite une compatibilité de fonctionnement entre le compteur et le capteur de détection d'impulsions.

La présente invention a pour but de résoudre les inconvénients précités et de proposer un procédé de configuration d'un dispositif de lecture et d'enregistrement d'impulsions destiné à effectuer une lecture d'au moins un compteur émettant des impulsions, ainsi qu'un dispositif de lecture et d'enregistrement d'impulsions, permettant de configurer le dispositif de lecture et d'enregistrement d'impulsions quel que soit le type de consommation à mesurer par un capteur de détection d'impulsions connecté à un compteur tout en utilisant un capteur de détection d'impulsions étant indépendant du type de consommation à mesurer.

### EXPOSE DE L'INVENTION

A cet effet, la présente invention vise, selon un premier aspect, un procédé de configuration d'un dispositif de lecture et d'enregistrement d'impulsions destiné à effectuer une lecture d'au moins un compteur émettant des impulsions, le compteur étant apte à générer des impulsions pour un type donné de consommation à mesurer, ledit dispositif comprenant au moins un capteur de détection d'impulsions et au moins un dispositif de mémorisation de données, le capteur de détection d'impulsions étant connecté au compteur, procédé qui comprend au moins:
- une acquisition d'une donnée relative au type donné de consommation à mesurer, le type donné de consommation à mesurer étant dépendant du compteur ;
- une mémorisation par un dispositif de mémorisation de données de ladite donnée acquise relative au type donné de consommation à mesurer par l'intermédiaire dudit capteur de détection d'impulsions connecté audit compteur.

Ainsi, le procédé de configuration d'un dispositif de lecture et d'enregistrement d'impulsions permet de lire et d'enregistrer des impulsions générées par un compteur au moyen d'un capteur de détection d'impulsions quel que soit le type de consommation à mesurer.

De cette manière, le dispositif de lecture et d'enregistrement d'impulsions comprend un capteur de détection d'impulsions dit universel connecté à un compteur de sorte à compter le nombre d'impulsions émises par le compteur quel que soit le type de consommation à mesurer.

L'acquisition d'une donnée relative au type de consommation à mesurer par l'intermédiaire d'un capteur de détection d'impulsions connecté à un compteur permet de déterminer une première information de sorte à configurer le dispositif de lecture et d'enregistrement d'impulsions, où une impulsion à lire et à enregistrer par le dispositif de lecture et d'enregistrement d'impulsions est définie par le type de consommation mesurée par le compteur.

Suivant un mode de réalisation préféré, la donnée acquise relative au type donné de consommation à mesurer et est distinguée parmi une liste de types de consommation à mesurer.

La liste de plusieurs types de consommation à mesurer peut inclure par exemple une ou plusieurs des consommations à mesurer suivantes : le gaz, l'électricité, l'énergie thermique ou l'eau.

De préférence, l'étape d'acquisition d'une donnée relative au type donné de consommation à mesurer est mise en oeuvre par une saisie par un utilisateur de la consommation à mesurer au travers de moyens de sélection d'un terminal du dispositif de lecture et d'enregistrement d'impulsions.

Selon une caractéristique préférée de l'invention, ledit procédé comprend :
- une acquisition d'une valeur de la consommation à mesurer par l'intermédiaire dudit capteur de détection d'impulsions connecté audit compteur correspondant à une impulsion dudit compteur,
- une mémorisation par ledit dispositif de mémorisation de données de ladite valeur acquise de la consommation à mesurer par l'intermédiaire dudit capteur de détection d'impulsions connecté audit compteur correspondant à une impulsion dudit compteur.

Ainsi, la valeur de la consommation à mesurer par l'intermédiaire du capteur de détection d'impulsions connecté au compteur correspondant à une impulsion du compteur peut prendre toute valeur, et n'est pas limitée par un nombre de positions prédéterminées pouvant être prises par un moyen de sélection associé au capteur de détection d'impulsions.

De cette manière, la configuration du dispositif de lecture et d'enregistrement d'impulsions en fonction de la valeur acquise de la consommation à mesurer par l'intermédiaire du capteur de détection d'impulsions connecté au compteur correspondant à une impulsion du compteur permet de s'affranchir d'une compatibilité de fonctionnement à garantir entre le compteur et le capteur de détection d'impulsions.

La mémorisation de ladite valeur acquise de la consommation à mesurer correspondant à une impulsion du compteur et la mémorisation par de ladite donnée acquise relative au type de consommation à mesurer peuvent être simultanées ou séquencées.

L'acquisition d'une donnée relative à la valeur de consommation à mesurer par l'intermédiaire du capteur de détection d'impulsions connecté au compteur correspondant à une impulsion du compteur permet de déterminer une deuxième information de sorte à configurer le dispositif de lecture et d'enregistrement d'impulsions, où une impulsion à lire et à enregistrer par le dispositif de lecture et d'enregistrement d'impulsions est définie par la valeur de consommation mesurée par le compteur correspondant à une impulsion du compteur.

Selon une autre caractéristique préférée de l'invention, ledit procédé comprend :
- une initialisation d'une valeur de départ dudit dispositif de mémorisation de données,
- une mémorisation par ledit dispositif de mémorisation de données de ladite valeur de départ.

Ainsi, le procédé de configuration d'un dispositif de lecture et d'enregistrement d'impulsions permet de lire et d'enregistrer des impulsions générées par un compteur au moyen d'un capteur de détection d'impulsions en partant d'une valeur zéro de sorte à effectuer un nouvel enregistrement, ou bien d'une valeur prédéterminée de sorte à effectuer un suivi de consommation à partir d'au moins un enregistrement précédent.

L' initialisation d'une valeur de départ du dispositif de mémorisation de données permet de déterminer une troisième information de sorte à configurer le dispositif de lecture et d'enregistrement d'impulsions, où une impulsion à lire et à enregistrer par le dispositif de lecture et d'enregistrement d'impulsions est incrémentée à la valeur de départ mémorisée dans le dispositif de mémorisation de données. On peut notamment prévoir que ladite valeur de départ dudit dispositif de mémorisation de données soit équivalente à une valeur affichée par ledit compteur.

Pour faciliter la configuration du dispositif, on peut prévoir que tout ou partie du procédé soit effectué par l'intermédiaire d'un terminal, par exemple un terminal pourvu d'une interface visuelle et tactile. On peut prévoir notamment une transmission de données entre un terminal et ledit dispositif de mémorisation de données lors de l'acquisition d'une donnée relative au type de consommation à mesurer, de l'acquisition d'une valeur de la consommation à mesurer et/ou de l'initialisation. Cette transmission de données peut notamment être mise en oeuvre à distance par transmission radio.

La présente invention vise, selon un deuxième aspect, un procédé de commande en fonctionnement d'un dispositif de lecture et d'enregistrement d'impulsions.

Selon l'invention, ledit procédé comprend une lecture et un enregistrement d'impulsions émises par au moins un compteur, en fonction de au moins la mémorisation, par le procédé de configuration dudit dispositif de lecture et d'enregistrement d'impulsions conforme à l'invention, d'une donnée relative au type de consommation à mesurer, et le cas échéant de la mémorisation par le procédé de configuration d'une valeur de la consommation à mesurer.

Ainsi, le procédé de commande en fonctionnement est mis en oeuvre suite à la configuration du dispositif de lecture et d'enregistrement d'impulsions de sorte à garantir une communication cohérente entre au moins un compteur et le dispositif de lecture et d'enregistrement d'impulsions comprenant le dispositif de mémorisation de données et au moins un capteur de détection d'impulsions.

On peut alors prévoir l'affichage de la consommation mesurée, en fonction du nombre d'impulsions lues par ledit capteur de détection d'impulsions lors de la lecture et de l'enregistrement d'impulsions et de ladite valeur acquise de la consommation à mesurer correspondant à une impulsion dudit compteur

La présente invention vise, selon un troisième aspect, un dispositif de lecture et d'enregistrement d'impulsions destiné à effectuer une lecture d'au moins un compteur émettant des impulsions, ledit dispositif comprenant au moins un capteur de détection d'impulsions, au moins un dispositif de mémorisation de données et des moyens de commande configurés pour mettre en oeuvre le procédé de configuration selon l'invention.

Ce dispositif de lecture et d'enregistrement d'impulsions présente des caractéristiques et avantages analogues à ceux décrits précédemment en relation avec le procédé de configuration selon l'invention.

De préférence, ledit dispositif comprend un terminal, ledit terminal comprenant des moyens de sélection et des moyens d'affichage et pouvant notamment être un terminal mobile, en particulier un téléphone intelligent ou une tablette. En particulier, le terminal peut être pourvu de moyens de sélection permettant à un utilisateur de saisir la donnée relative au type donné de consommation. Le terminal est de préférence également pourvu de moyens de transmission de données pour assurer une transmission de données entre le terminal et ledit dispositif de mémorisation de données lors de l'acquisition d'une donnée relative au type de consommation à mesurer, de l'acquisition d'une valeur de la consommation à mesurer et/ou de l'initialisation. Ces moyens de transmission de données peuvent notamment inclure des moyens de transmission radio.

Le dispositif comprend une pluralité de compteurs, connectés respectivement à des capteurs de détection d'impulsions différents. Il peut également comprendre un capteur de détection d'impulsions connecté à une pluralité de compteurs. L'invention est particulièrement avantageuse dans le cas où les compteurs ne comptent pas tous des grandeurs physiques d'un même type, par exemple un compteur de gaz et un compteur d'électricité, ou un compteur d'eau chaude et un compteur de gaz, ou tout autre combinaison de deux ou plusieurs types de compteurs et consommations à mesurer.

L'invention vise également un dispositif de lecture et d'enregistrement d'impulsions destiné à effectuer une lecture d'au moins un compteur émettant des impulsions, ledit dispositif comprenant au moins un capteur de détection d'impulsions, au moins un dispositif de mémorisation de données, et des moyens de commande configurés pour mettre en oeuvre ledit procédé de commande décrit précédemment.

La présente invention vise, selon un quatrième aspect, une installation comprenant au moins un système consommateur d'énergie et/ou d'eau et un dispositif de lecture et d'enregistrement d'impulsions selon l'invention.

### BREVE DESCRIPTION DES FIGURES

D'autres particularités et avantages de l'invention apparaîtront encore dans la description ci-après.

Aux dessins annexés, donnés à titre d'exemples non limitatifs :
- la figure 1 est une vue schématique d'un dispositif de lecture et d'enregistrement d'impulsions émises par un compteur conforme à un premier mode de réalisation de l'invention ;
- la figure 2 est une vue schématique d'un dispositif de lecture et d'enregistrement d'impulsions émises par un compteur conforme à un deuxième mode de réalisation de l'invention ;
- la figure 3 est une vue schématique d'un dispositif de lecture et d'enregistrement d'impulsions émises par un compteur conforme à un troisième mode de réalisation de l'invention ;
- la figure 4 est une vue schématique d'un dispositif de lecture et d'enregistrement d'impulsions émises par plusieurs compteurs conforme à un quatrième mode de réalisation de l'invention ;
- la figure 5 est une vue schématique d'un dispositif de lecture et d'enregistrement d'impulsions émises par plusieurs compteurs conforme à un cinquième mode de réalisation de l'invention ;
- la figure 6 est une vue schématique d'un dispositif de lecture et d'enregistrement d'impulsions émises par plusieurs compteurs conforme à un sixième mode de réalisation de l'invention ;
- la figure 7 est un algorithme décrivant un procédé de configuration d'un dispositif de lecture et d'enregistrement d'impulsions conforme à un mode de réalisation de l'invention ; et
- la figure 8 est un algorithme décrivant un procédé de commande en fonctionnement d'un dispositif de lecture et d'enregistrement d'impulsions conforme à un mode de réalisation de l'invention.

### DESCRIPTION DETAILLEE D'UN MODE DE REALISATION

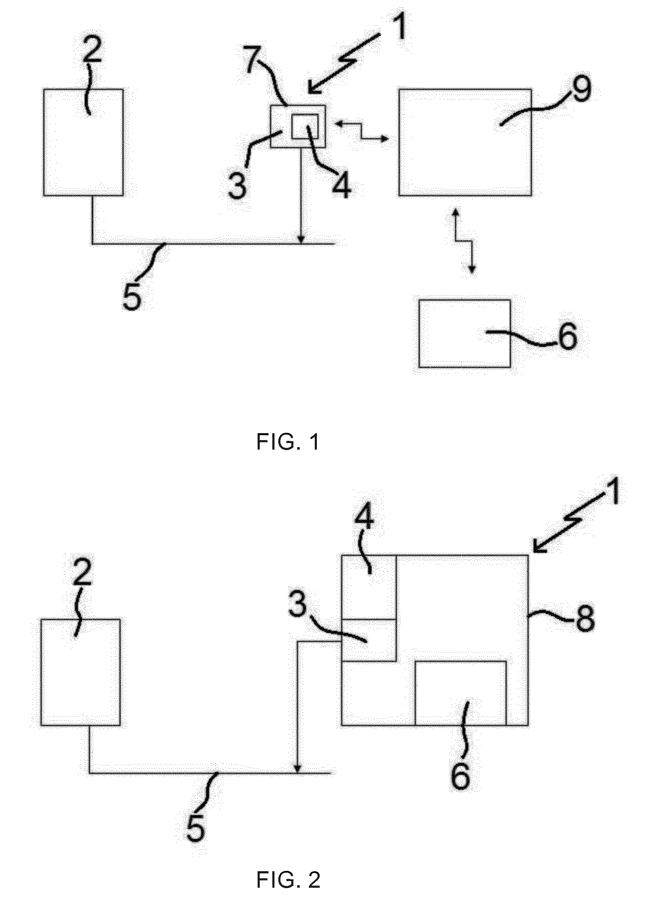

On va décrire tout d'abord, en référence aux figures 1 à 6, un dispositif de lecture et d'enregistrement d'impulsions conforme à l'invention.

Le dispositif de lecture et d'enregistrement d'impulsions 1 est destiné à effectuer une lecture d'au moins un compteur 2 assurant de façon autonome une mesure d'une grandeur physique et l'affichage de la grandeur physique mesurée, et générant en parallèle des impulsions, en particulier des impulsions électriques correspondant à des incréments de la grandeur physique mesurée.

Le dispositif de lecture et d'enregistrement d'impulsions 1 comprend au moins un capteur de détection d'impulsions 3 et au moins un dispositif de mémorisation de données 4.

Dans un mode de réalisation, tel qu'illustré aux figures 1 à 3, le dispositif de lecture et d'enregistrement d'impulsions 1 comprend un capteur de détection d'impulsions 3 et un dispositif de mémorisation de données 4, où le capteur de détection d'impulsions 3 est connecté à un compteur 2.

Ici, le capteur de détection d'impulsions 3 est connecté au compteur 2 au moyen d'un conducteur électrique filaire 5, par exemple au nombre de deux fils.

Le capteur de détection d'impulsions 3 est adapté à lire des impulsions émises par le compteur 2, où les impulsions correspondent au passage d'un état ouvert à un état fermé d'un commutateur du compteur 2.

L'émission des impulsions par un compteur 2 est définie par la norme CEI 62053-31.

Préférentiellement, le dispositif de lecture et d'enregistrement d'impulsions 1 comprend également un terminal 6, le terminal 6 comprenant des moyens de sélection et des moyens d'affichage.

Dans un mode de réalisation, les moyens de sélection et les moyens d'affichage sont réalisés au moyen d'un écran tactile.

Bien entendu, le mode de réalisation des moyens de sélection et des moyens d'affichage n'est nullement limitatif et peut être différent, en particulier réalisé au moyen de boutons poussoirs ou de touches sensitives pour les moyens de sélection, et d'un afficheur LCD (acronyme du terme anglo-saxon « Liquid Crystal Display ») ou TFT (acronyme du terme anglo-saxon « Thin Film Transistor ») pour les moyens d'affichage.

Dans un mode de réalisation tel qu'illustré à la figure 1, le dispositif de mémorisation de données 4 est intégré dans le capteur de détection d'impulsions 3, en particulier dans un boîtier 7 du capteur de détection d'impulsions 3.

Dans un autre mode de réalisation tel qu'illustré à la figure 2, le dispositif de lecture et d'enregistrement d'impulsions 1 comprend un boîtier 8 à l'intérieur duquel sont disposés le dispositif de mémorisation de données 4 et le terminal 6, le dispositif de mémorisation de données 4 et le terminal 6 étant reliés entre eux par une connexion filaire.

Ici, le boîtier 8 du dispositif de lecture et d'enregistrement d'impulsions 1 comprend également ledit au moins un capteur de détection d'impulsions 3, et le dispositif de mémorisation de données 4 et ledit au moins un capteur de détection d'impulsions 3 sont reliés entre eux par une connexion filaire.

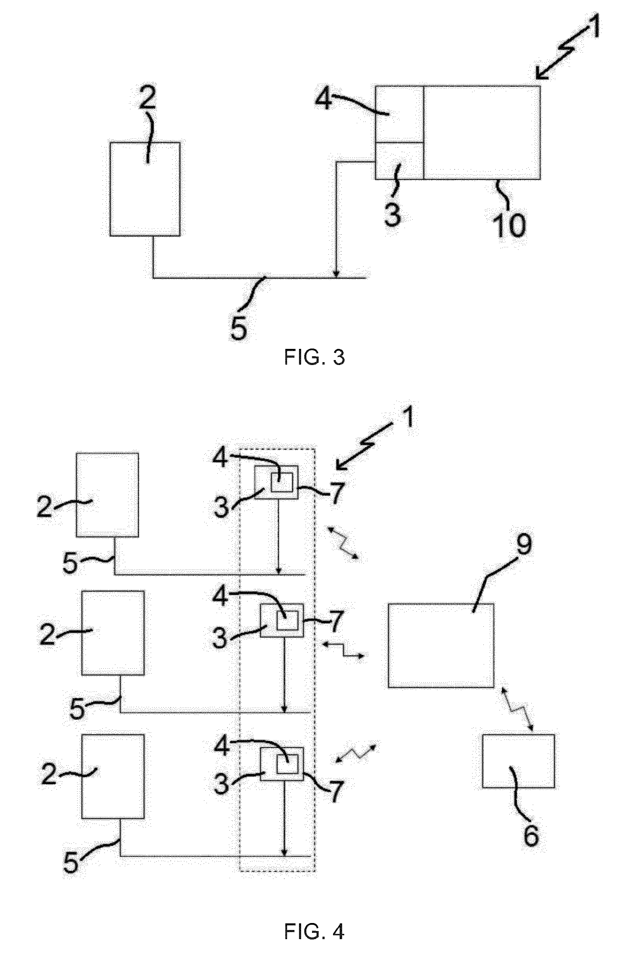

Dans un autre mode de réalisation tel qu'illustré à la figure 3, le dispositif de lecture et d'enregistrement d'impulsions 1 comprend un boîtier 10 à l'intérieur duquel sont disposés le capteur de détection d'impulsions 3 et le dispositif de mémorisation de données 4, le capteur de détection d'impulsions 3 et le dispositif de mémorisation de données 4 étant reliés entre eux par une connexion filaire.

Ici, le boîtier 10 du dispositif de lecture et d'enregistrement d'impulsions 1 est dépourvu d'un terminal.

Dans un mode de réalisation, le capteur de détection d'impulsions 3 comprend des moyens de comptage du nombre d'impulsions reçues depuis le compteur 2, en particulier un compteur d'incrémentation d'une valeur.

A titre d'exemple nullement limitatif, les moyens de comptage du nombre d'impulsions reçues depuis le compteur 2 du capteur de détection d'impulsions 3 peuvent comprendre une résistance de tirage, encore appelée résistance de « pull up ».

Dans un mode de réalisation, les impulsions reçues depuis le compteur 2 et lues par le capteur de détection d'impulsions 3 sont enregistrées dans une mémoire du dispositif de mémorisation de données 4.

Ici et de manière nullement limitative, la longueur des impulsions reçues depuis le compteur 2 et lues par le capteur de détection d'impulsions 3 est indifférente, étant donné que le dispositif de mémorisation de données 4 mémorise un nombre d'impulsions lues par le capteur de détection d'impulsions 3, où chaque impulsion correspond à une valeur de la consommation mesurée dépendante du compteur 2, et notamment pendant toute la période de mise en service du dispositif de lecture et d'enregistrement d'impulsions 1.

Ici, le capteur de détection d'impulsions 3 et le dispositif de mémorisation de données 4 forment deux unités distinctes, une liaison de communication est établie entre ces deux unités de sorte d'une part à lire et à comptabiliser les impulsions reçues depuis le compteur 2 par le capteur de détection d'impulsions 3, et d'autre part à enregistrer les impulsions comptées par le capteur de détection d'impulsions 3 dans la mémoire du dispositif de mémorisation de données 4.

Dans un mode de réalisation, le dispositif de lecture et d'enregistrement d'impulsions 1 comprend des moyens de conversion d'une impulsion en une valeur de la consommation à mesurer. Ces moyens de conversion peuvent faire partie par exemple d'un microcontrôleur.

Ici, les moyens de conversion d'une impulsion en une valeur de la consommation à mesurer peuvent être intégrés dans le capteur de détection d'impulsions 3.

Bien entendu, les moyens de conversion d'une impulsion en une valeur de la consommation à mesurer peuvent être disposés dans un autre élément du dispositif de lecture et d'enregistrement d'impulsions, voire en dehors de celui-ci, et par exemple dans un serveur de communication disposé entre le dispositif de lecture et d'enregistrement d'impulsions et un terminal.

Le dispositif de lecture et d'enregistrement d'impulsions 1, en particulier le capteur de détection d'impulsions 3, peut être alimenté par une batterie, ou encore par un réseau d'alimentation en énergie électrique.

On notera que les figures 1 à 3 sont schématiques et que de nombreux organes nécessaires au fonctionnement du dispositif de lecture et d'enregistrement d'impulsions 1 ont été omis et n'ont pas besoin d'être décrits en détail ici.

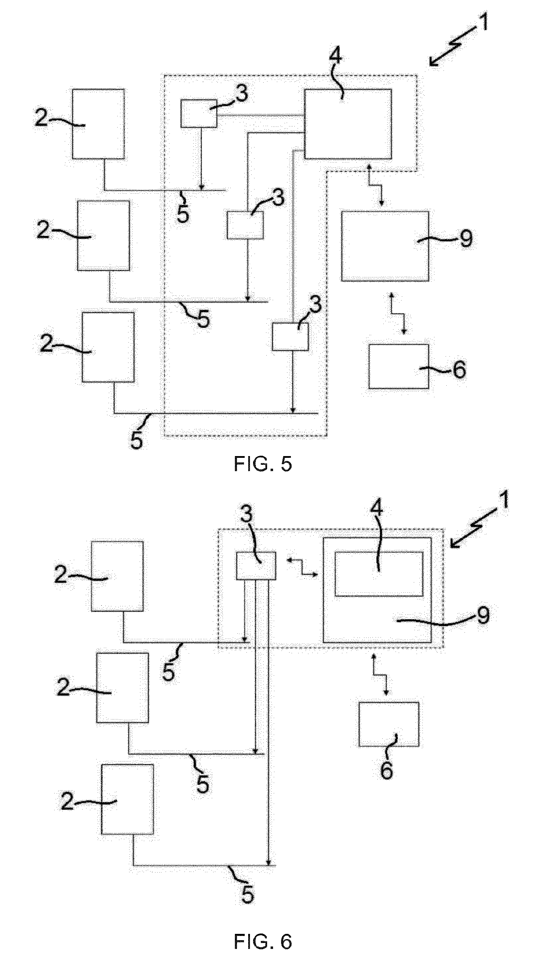

Dans un mode réalisation tel qu'illustré aux figures 4 et 5, le dispositif de lecture et d'enregistrement d'impulsions 1 comprend une pluralité de compteurs 2, où les compteurs 2 sont connectés respectivement à un capteur de détection d'impulsions 3 différent.

Ainsi, chaque capteur de détection d'impulsions 3 effectue une lecture des impulsions émises par un seul compteur 2.

De cette manière, un tel dispositif de lecture et d'enregistrement d'impulsions 1 comprend autant de capteurs de détection d'impulsions 3 que de compteurs 2 de sorte à lire et à enregistrer individuellement les impulsions émises par un compteur 2 par un capteur de détection d'impulsions 3.

Les capteurs de détection d'impulsion 3 sont alors de préférence tous identiques, seule leur configuration étant susceptible de varier en fonction du compteur 2 associé.

En outre, les capteurs de détection d'impulsions 3 d'un tel dispositif de lecture et d'enregistrement d'impulsions 1 peuvent comprendre un unique port d'entrée destiné à lire les impulsions d'un compteur 2 de sorte à minimiser les coûts d'obtention des capteurs de détection d'impulsions 3.

De cette manière, le dispositif de lecture et d'enregistrement d'impulsions 1 permet de déterminer plusieurs consommations au moyen de capteurs de détection d'impulsions 3 étant associés chacun à un seul compteur 2 émettant des impulsions d'une consommation à mesurer.

En référence à la figure 4, tel que décrit dans le mode de réalisation de la figure 1, un dispositif de mémorisation de données 4 est intégré dans chaque capteur de détection d'impulsions 3, en particulier dans un boîtier 7 du capteur de détection d'impulsions 3.

En référence à la figure 5, le dispositif de lecture et d'enregistrement d'impulsions 1 comprend un unique dispositif de mémorisation de données 4 pour l'ensemble des capteurs de détection d'impulsions 3.

Dans un autre mode réalisation tel qu'illustré à la figure 6, le dispositif de lecture et d'enregistrement d'impulsions 1 comprend un capteur de détection d'impulsions 3 connecté à une pluralité de compteurs 2.

Ainsi, un unique capteur de détection d'impulsions 3 effectue une lecture des impulsions émises respectivement par plusieurs compteurs 2.

De cette manière, un tel dispositif de lecture et d'enregistrement d'impulsions 1 comprend un capteur de détection d'impulsions 3 connecté à plusieurs compteurs 2 de sorte à lire et à enregistrer respectivement les impulsions émises par un ensemble de compteurs 2 au moyen d'un seul capteur de détection d'impulsions 3.

En outre, le capteur de détection d'impulsions 3 d'un tel dispositif de lecture et d'enregistrement d'impulsions 1 comprend une pluralité de ports d'entrée destinés à lire chacun les impulsions d'un des compteurs 2 de sorte à minimiser les coûts d'obtention du dispositif de lecture et d'enregistrement d'impulsions 1.

De cette manière, le dispositif de lecture et d'enregistrement d'impulsions 1 permet de déterminer plusieurs consommations au moyen d'un seul capteur de détection d'impulsions 3 associé à plusieurs compteurs 2 émettant respectivement des impulsions d'une consommation à mesurer.

Dans un mode de réalisation tel qu'illustré aux figures 1 à 5, le dispositif de mémorisation de données 4 et ledit au moins un capteur de détection d'impulsions 3 sont reliés par une connexion électrique filaire.

Dans un mode de réalisation tel qu'illustré à la figure 6, le dispositif de mémorisation de données 4 et ledit au moins un capteur de détection d'impulsions 3 sont distants, et le dispositif de lecture et d'enregistrement d'impulsions 1 met en oeuvre une communication par transmission radio entre le dispositif de mémorisation de données 4 et ledit au moins un capteur de détection 3, et inversement.

Avantageusement, le dispositif de mémorisation de données 4 est intégré dans un serveur de communication 9, tel qu'illustré à la figure 6.

Dans un mode de réalisation tel qu'illustré aux figures 1 et 4 à 6, le dispositif de mémorisation de données 4 et le terminal 6 sont distants, et le dispositif de lecture et d'enregistrement d'impulsions 1 met en oeuvre une communication par transmission radio entre le dispositif de mémorisation de données 4 et le terminal 6, et inversement.

Avantageusement, le terminal 6 est un terminal mobile, en particulier un téléphone intelligent.

Ici et de manière nullement limitative, la communication par transmission radio entre le dispositif de mémorisation de données 4 et le terminal 6, et inversement, est mise en oeuvre par l'intermédiaire d'un serveur de communication 9.

On va décrire à présent une installation conforme à un mode de réalisation de l'invention.

L'installation comprend au moins un système consommateur d'énergie et/ou d'eau (non représenté) et un dispositif de lecture et d'enregistrement d'impulsions 1.

Ledit au moins un système consommateur d'énergie et/ou d'eau peut être par exemple un dispositif de chauffage, tel que des radiateurs, un ballon d'eau chaude, une chaudière, ou encore des équipements électriques d'une habitation.

Un système consommateur d'énergie et/ou d'eau est connecté à au moins un compteur 2 de sorte à mesurer la ou les consommations engendrées par celui-ci. Puis, des impulsions sont émises par le ou les compteurs 2 de sorte à être lues et enregistrées par le dispositif de lecture et d'enregistrement d'impulsions 1, en particulier au moyen d'au moins un capteur de détection d'impulsions 3 et d'au moins un dispositif de mémorisation de données 4.

Bien entendu, le dispositif de lecture et d'enregistrement d'impulsions conforme à l'invention comporte l'ensemble des équipements et moyens nécessaires à la mise en oeuvre d'un processus de fonctionnement classique dans une telle installation.

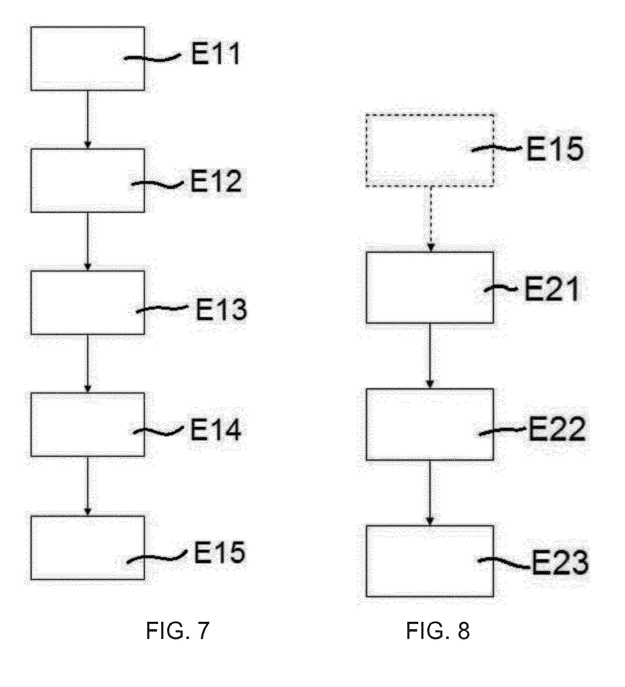

On va décrire à présent, en référence à la figure 7, un procédé de configuration d'un dispositif de lecture et d'enregistrement d'impulsions conforme à un mode de réalisation de l'invention.

Le procédé de configuration du dispositif de lecture et d'enregistrement d'impulsions 1 comprend une étape d'acquisition E11 d'une donnée relative au type de consommation à mesurer par l'intermédiaire d'un capteur de détection d'impulsions 3 connecté à un compteur 2.

La donnée acquise relative au type de consommation à mesurer est dépendante du compteur 2 auquel le capteur de détection d'impulsions 3 est associé.

Dans un mode de réalisation, la donnée acquise relative au type de consommation à mesurer est une désignation prédéterminée correspondant au type de compteur 2 permettant de distinguer la consommation à mesurer, en particulier parmi une liste de types de consommation à mesurer.

A titre d'exemple nullement limitatif, la consommation à mesurer peut être le gaz, l'électricité, l'énergie thermique ou l'eau.

Le procédé comprend également une étape de mémorisation E15 par un dispositif de mémorisation de données de la donnée acquise relative au type de consommation à mesurer par l'intermédiaire du capteur de détection d'impulsions 3 connecté au compteur 2.

Ainsi, le procédé de configuration d'un dispositif de lecture et d'enregistrement d'impulsions 1 permet de lire et d'enregistrer des impulsions générées par un compteur 2 au moyen d'un capteur de détection d'impulsions 3 quel que soit le type de consommation à mesurer.

De cette manière, le dispositif de lecture et d'enregistrement d'impulsions 1 comprend un capteur de détection d'impulsions 3 dit universel connecté à un compteur 2 de sorte à compter le nombre d'impulsions émises par le compteur 2 quel que soit le type de consommation à mesurer.

L'étape d'acquisition E11 d'une donnée relative au type de consommation à mesurer par l'intermédiaire d'un capteur de détection d'impulsions 3 connecté à un compteur 2 permet de déterminer une première information de sorte à configurer le dispositif de lecture et d'enregistrement d'impulsions 1, où une impulsion à lire et à enregistrer par le dispositif de lecture et d'enregistrement d'impulsions 1 est définie par le type de consommation mesurée par le compteur 2.

Par ailleurs, le dispositif de lecture et d'enregistrement d'impulsions 1 permet de prendre en considération le type de consommation à mesurer pour la transmission de données entre le terminal 6 et le dispositif de mémorisation de données 4.

Préférentiellement, le procédé comprend en outre une étape d'acquisition E12 d'une valeur de la consommation à mesurer par l'intermédiaire du capteur de détection d'impulsions 3 connecté au compteur 2 correspondant à une impulsion du compteur 2.

A titre d'exemple nullement limitatif, la valeur acquise de la consommation à mesurer correspondant à une impulsion du compteur 2 est déterminée par la lecture de l'utilisateur des informations mentionnées sur le compteur 2, ou encore des informations précisées dans une notice d'utilisation du compteur 2.

L'étape de mémorisation E15 mémorise également par le dispositif de mémorisation de données 4 la valeur acquise de la consommation à mesurer par l'intermédiaire du capteur de détection d'impulsions 3 connecté au compteur 2 correspondant à une impulsion du compteur 2.

Ainsi, la valeur de la consommation à mesurer par l'intermédiaire du capteur de détection d'impulsions 3 connecté au compteur 2 correspondant à une impulsion du compteur 2 peut prendre toute valeur, et n'est pas limitée par un nombre de positions prédéterminées pouvant être prises par un moyen de sélection associé au capteur de détection d'impulsions 2.

L'étape d'acquisition E12 d'une donnée relative à la valeur de consommation à mesurer par l'intermédiaire du capteur de détection d'impulsions 3 connecté au compteur 2 correspondant à une impulsion du compteur 2 permet de déterminer une deuxième information de sorte à configurer le dispositif de lecture et d'enregistrement d'impulsions 1, où une impulsion à lire et à enregistrer par le dispositif de lecture et d'enregistrement d'impulsions 1 est définie par la valeur de consommation mesurée par le compteur 2 correspondant à une impulsion du compteur 2.

A titre d'exemple nullement limitatif, la valeur de la consommation à mesurer correspondant à une impulsion du compteur 2 peut être un nombre de kWh pour une consommation d'énergie thermique ou d'électricité, ou un nombre de m3 pour une consommation d'eau ou de gaz, qui est mémorisée dans le dispositif de mémorisation de données 4 suite à la mise en oeuvre des étapes d'acquisition E12 et de mémorisation E15.

De cette manière, la configuration du dispositif de lecture et d'enregistrement d'impulsions 1 en fonction de la valeur acquise de la consommation à mesurer par l'intermédiaire du capteur de détection d'impulsions 3 connecté au compteur 2 correspondant à une impulsion du compteur 2 permet de s'affranchir d'une compatibilité de fonctionnement à garantir entre le compteur 2 et le capteur de détection d'impulsions 3.

Avantageusement, le procédé comprend une étape d'initialisation E13 d'une valeur de départ du dispositif de mémorisation de données 4.

L'étape de mémorisation E15 mémorise également par le dispositif de mémorisation de données 4 la valeur de départ.

Ainsi, le procédé de configuration d'un dispositif de lecture et d'enregistrement d'impulsions 1 permet de lire et d'enregistrer des impulsions générées par un compteur 2 au moyen d'un capteur de détection d'impulsions 3 en partant d'une valeur zéro de sorte à effectuer un nouvel enregistrement, ou bien d'une valeur prédéterminée de sorte à effectuer un suivi de consommation à partir d'au moins un enregistrement précédent.

L'étape d'initialisation E13 d'une valeur de départ du dispositif de mémorisation de données 4 permet de déterminer une troisième information de sorte à configurer le dispositif de lecture et d'enregistrement d'impulsions 1, où une impulsion à lire et à enregistrer par le dispositif de lecture et d'enregistrement d'impulsions 1 est incrémentée à la valeur de départ mémorisée dans le dispositif de mémorisation de données 4.

Préférentiellement, la valeur de départ du dispositif de mémorisation de données 4 est équivalente à une valeur affichée par le compteur 2.

Ainsi, la valeur de consommation pouvant être saisie et affichée par le terminal 6 du dispositif de lecture et d'enregistrement d'impulsions 1 peut être identique à celle du compteur 2 de sorte à garantir la cohérence des données entre le compteur 2 et le dispositif de lecture et d'enregistrement d'impulsions 1, et par la suite de permettre à un utilisateur de suivre une consommation depuis le terminal 6, en particulier depuis un terminal mobile.

De cette manière, l'utilisateur peut suivre une consommation depuis un terminal 6 sans avoir à lire directement des données sur le compteur 2.

Ici, la valeur de départ d'initialisation du dispositif de mémorisation de données 4 est déterminée par la lecture de l'utilisateur de la valeur mesurée étant affichée par le compteur 2.

En outre, le dispositif de lecture et d'enregistrement d'impulsions 1 permet de suivre la consommation mesurée par un compteur 2 au moyen dudit au moins un capteur de détection d'impulsions 3 et du dispositif de mémorisation de données 4 au cours du temps, par exemple au moyen de courbes affichées par des moyens d'affichage du terminal 6, et de pouvoir consulter un historique à partir des données enregistrées dans le dispositif de mémorisation de données 4.

Dans un mode de réalisation tel qu'illustré aux figures 1, 2, et 4 à 6, le procédé comprend une étape de transmission de données E14 entre le terminal 6 et le dispositif de mémorisation de données 4 lors de l'étape de mémorisation E15 du dispositif de lecture et d'enregistrement d'impulsions 1, le terminal 6 étant configuré à permettre la mise en oeuvre d'au moins l'une des étapes d'acquisition E11, E12 et d'initialisation E13.

Ici, les étapes d'acquisition E11, E12 d'une donnée relative au type de consommation à mesurer, d'une valeur de la consommation à mesurer correspondant à une impulsion du compteur 2, et/ou d'initialisation E13 d'une valeur de départ du dispositif de mémorisation de données 4 sont mises en oeuvre dans le dispositif de mémorisation de données 4 du dispositif de lecture et d'enregistrement d'impulsions 1 au travers des moyens de sélection du terminal 6.

Préférentiellement, les étapes d'acquisition E11, E12 d'une donnée relative au type de consommation à mesurer, d'une valeur de la consommation à mesurer correspondant à une impulsion du compteur 2, et/ou d'initialisation E13 d'une valeur de départ du dispositif de mémorisation de données 4 sont mises en oeuvre par un utilisateur, ou encore par un installateur, et les informations associées sont saisies dans le dispositif de mémorisation de données 4 du dispositif de lecture et d'enregistrement d'impulsions 1 au travers des moyens de sélection du terminal 6.

Avantageusement, l'étape de transmission de données E14 entre le terminal 6 et le dispositif de mémorisation de données 4 est mise en oeuvre à distance par transmission radio, tel qu'illustré aux figures 1, et 4 à 6.

Dans un premier cas, l'étape de transmission de données E14 entre le terminal 6 et le dispositif de mémorisation de données 4 peut être mise en oeuvre suite à la réalisation de chacune des étapes d'acquisition E11, E12 et d'initialisation E13.

Dans un deuxième cas, l'étape de transmission de données E14 entre le terminal 6 et le dispositif de mémorisation de données 4 peut être mise en oeuvre suite à la réalisation de l'ensemble des étapes d'acquisition E11, E12 et d'initialisation E13.

Dans un autre mode de réalisation tel qu'illustré à la figure 3, le procédé comprend une étape de transmission de données E14 entre le compteur 2 et le dispositif de mémorisation de données 4 lors de l'étape de mémorisation E15 du dispositif de lecture et d'enregistrement d'impulsions 1, le compteur 2 étant configuré à permettre la mise en oeuvre d'au moins l'une des étapes d'acquisition E11, E12 et d'initialisation E13.

Ici, les étapes d'acquisition E11, E12 d'une donnée relative au type de consommation à mesurer, d'une valeur de la consommation à mesurer correspondant à une impulsion du compteur 2, et/ou d'initialisation E13 d'une valeur de départ du dispositif de mémorisation de données 4 sont mises en oeuvre dans le dispositif de mémorisation de données 4 du dispositif de lecture et d'enregistrement d'impulsions 1 au moyen d'un protocole de communication entre le compteur 2 et le dispositif de mémorisation de données 4.

A titre d'exemple nullement limitatif, le protocole de communication entre le compteur 2 et le dispositif de mémorisation de données 4 peut être mis en oeuvre par transmission de trames d'un signal électrique.

Dans ce cas où le compteur 2 est communiquant, certaines au moins des données de configuration peuvent être déterminées automatiquement par le dispositif de lecture et d'enregistrement d'impulsions 1.

Ce mode de réalisation de configuration du dispositif de lecture et d'enregistrement d'impulsions 1 peut être mis en oeuvre par l'émission d'une requête émise depuis celui-ci vers le compteur 2 de sorte à générer une identification, puis en consultant une mémoire interne ou une base de données déportée du compteur 2 de sorte à relier un identifiant fourni par le compteur 2 avec au moins certaines données de configuration, par exemple le type de consommation à mesurer ou la valeur de la consommation à mesurer correspondant à une impulsion du compteur 2.

On va décrire à présent, en référence à la figure 8, un procédé de commande en fonctionnement d'un dispositif de lecture et d'enregistrement d'impulsions conforme à un mode de réalisation de l'invention.

Le procédé de commande en fonctionnement d'un dispositif de lecture et d'enregistrement d'impulsions 1 comprend une étape de lecture et d'enregistrement d'impulsions E21 émises par au moins un compteur 2, où l'étape de lecture et d'enregistrement d'impulsions E21 est mise en oeuvre en fonction de l'étape de mémorisation E15 du procédé de configuration du dispositif de lecture et d'enregistrement d'impulsions 1.

Ainsi, le dispositif de lecture et d'enregistrement d'impulsions 1 permet de mesurer une consommation qui est caractérisée par le ou les paramètres déterminés au cours du procédé de configuration du dispositif de lecture et d'enregistrement d'impulsions 1, en particulier d'une donnée relative au type de consommation à mesurer, et préférentiellement d'une valeur de la consommation à mesurer correspondant à une impulsion du compteur 2, et d'une valeur de départ d'initialisation du dispositif de mémorisation de données 4.

Le procédé comprend en outre une étape de conversion E22 des impulsions enregistrées par le dispositif de lecture et d'enregistrement d'impulsions 1 en une valeur de la consommation mesurée en fonction du nombre d'impulsions lues par le capteur de détection d'impulsions 3 lors de l'étape de lecture et d'enregistrement d'impulsions E21, et des valeurs acquises, d'une part relative au type de consommation à mesurer et d'autre part de la consommation à mesurer correspondant à une impulsion du compteur 2.

Dans un mode de réalisation, l'étape de conversion E22 des impulsions enregistrées par le dispositif de lecture et d'enregistrement d'impulsions 1 en une valeur de la consommation mesurée est mise en oeuvre périodiquement par le dispositif de lecture et d'enregistrement d'impulsions 1, en particulier au moyen d'un microcontrôleur.

A titre d'exemple nullement limitatif, la période de mise en oeuvre de l'étape de conversion E22 peut être d'une heure.

Ici, le dispositif de lecture et d'enregistrement d'impulsions 1 peut comprendre une horloge de sorte à mettre en oeuvre l'étape de conversion E22 périodiquement.

Dans un autre mode de réalisation, l'étape de conversion E22 des impulsions enregistrées par le dispositif de lecture et d'enregistrement d'impulsions 1 en une valeur de la consommation mesurée est mise en oeuvre à chaque lecture d'une impulsion reçue depuis le compteur 2 au moyen du capteur de détection d'impulsions 3.

Le procédé comprend également une étape d'affichage E23, en particulier par les moyens d'affichage du terminal 6, de la consommation mesurée en fonction du nombre d'impulsions lues par le capteur de détection d'impulsions 3 lors de l'étape de lecture et d'enregistrement d'impulsions et de la valeur acquise de la consommation à mesurer correspondant à une impulsion du compteur 2, et préférentiellement de la valeur de départ d'initialisation du dispositif de mémorisation de données 4.

Ainsi, un utilisateur peut suivre une consommation depuis le terminal 6, en particulier depuis un terminal mobile, sans avoir à lire directement des données sur le compteur 2.

Avantageusement, l'étape d'affichage E23 de la consommation mesurée est mise en oeuvre suite à l'étape de conversion E22.

Dans un mode de réalisation, l'étape de conversion E22 est suivie d'une étape de transmission de données entre le dispositif de mémorisation de données 4 et le terminal 6, par exemple par transmission radio, de sorte à permettre la mise en oeuvre de l'étape d'affichage E23.

On va décrire un exemple de réalisation de configuration et de fonctionnement d'un dispositif de lecture et d'enregistrement d'impulsions conforme à l'invention.

Dans un premier temps, l'étape d'acquisition E11 d'une donnée relative au type de consommation à mesurer par l'intermédiaire d'un capteur de détection d'impulsions 3 connecté à un compteur 2 est mise en oeuvre par une saisie de l'utilisateur de la consommation à mesurer au travers des moyens de sélection du terminal 6.

Suite à la saisie par l'utilisateur de la consommation à mesurer au travers des moyens de sélection du terminal 6, cette première information est transmise lors de l'étape de transmission de données E14 entre le terminal 6 et le dispositif de mémorisation de données 4 puis enregistrée dans une mémoire du dispositif de mémorisation de données 4.

Dans un deuxième temps, l'étape d'acquisition E12 d'une valeur de la consommation à mesurer par l'intermédiaire du capteur de détection d'impulsions 3 connecté au compteur 2 correspondant à une impulsion du compteur 2 est mise en oeuvre par une saisie de l'utilisateur de la valeur de la consommation à mesurer correspondant à une impulsion du compteur 2 au travers des moyens de sélection du terminal 6.

Suite à la saisie par l'utilisateur de la valeur de la consommation à mesurer correspondant à une impulsion du compteur 2 au travers des moyens de sélection du terminal 6, cette deuxième information est transmise lors de l'étape de transmission de données E14 entre le terminal 6 et le dispositif de mémorisation de données 4 puis enregistrée dans la mémoire du dispositif de mémorisation de données 4.

Dans un troisième temps, l'étape d'initialisation E13 d'une valeur de départ du dispositif de mémorisation de données 4 est mise en oeuvre par une saisie de l'utilisateur de la valeur de départ au travers des moyens de sélection du terminal 6.

Suite à la saisie par l'utilisateur de la valeur de départ du dispositif de mémorisation de données 4 au travers des moyens de sélection du terminal 6, cette troisième information est transmise lors de l'étape de transmission de données E14 entre le terminal 6 et le dispositif de mémorisation de données 4 puis enregistrée dans la mémoire du dispositif de mémorisation de données 4.

Dans un autre mode de réalisation, les première, deuxième et troisième informations saisies au travers des moyens de sélection du terminal 6 sont stockées dans une mémoire du terminal 6 puis transmises simultanément lors de l'étape de transmission de données E14 entre le terminal 6 et le dispositif de mémorisation de données 4 puis enregistrées dans la mémoire du dispositif de mémorisation de données 4.

Puis, le dispositif de lecture et d'enregistrement d'impulsions 1 est configuré au cours de l'étape de mémorisation E15 en fonction des première, deuxième et troisième informations saisies préalablement au travers des moyens de sélection du terminal 6.

Cette étape de mémorisation E15 est mise en oeuvre par l'exécution de l'étape de transmission de données E14 entre le terminal 6 et le dispositif de mémorisation de données 4, où l'étape de transmission de données E14 est précédée d'une étape de validation par l'utilisateur au moyen du terminal 6 pour respectivement les première, deuxième et troisième informations.

Suite à la configuration du dispositif de lecture et d'enregistrement d'impulsions 1 mise en oeuvre suite à l'exécution de l'étape de mémorisation E15, le dispositif de lecture et d'enregistrement d'impulsions 1 met en oeuvre l'étape de lecture et d'enregistrement d'impulsions E21 émises par un compteur 2 au moyen du capteur de détection d'impulsions 3 et du dispositif de mémorisation de données 4.

Puis, les impulsions lues par le capteur de détection d'impulsions 3 et enregistrées par le dispositif de mémorisation de données 4 sont ensuite converties périodiquement en une valeur de consommation mesurée au cours de l'étape de conversion E22, en particulier au travers de moyens de conversion du dispositif de lecture et d'enregistrement d'impulsions 1, en fonction de la donnée relative au type de consommation à mesurer, de la valeur de la consommation à mesurer correspondant à une impulsion du compteur 2, et de la valeur de départ d'initialisation du dispositif de mémorisation de données 4.

Et suite à l'étape de conversion E22, la valeur de consommation mesurée est affichée au travers des moyens d'affichage du terminal 6 lors de l'étape d'affichage E23.

Le dispositif de lecture et d'enregistrement d'impulsions 1 comprend des moyens de commande constitués par au moins une unité électronique de contrôle (non représentée). Cette unité électronique de contrôle est apte à mettre en fonctionnement le dispositif de lecture et d'enregistrement d'impulsions conforme à l'invention.

Ainsi, l'unité électronique de contrôle commande notamment au moins un capteur de détection d'impulsions et au moins un dispositif de mémorisation de données de sorte d'une part à configurer le dispositif de lecture et d'enregistrement d'impulsions quel que soit le type de consommation à mesurer par un capteur de détection d'impulsions connecté à un compteur tout en utilisant un capteur de détection d'impulsions étant indépendant du type de consommation à mesurer, comme décrit précédemment, et d'autre part à commander en fonctionnement le dispositif de lecture et d'enregistrement d'impulsions.

L'unité électronique de contrôle peut être intégrée par exemple dans un capteur de détection d'impulsions 3, ou encore dans un serveur de communication 9.

Dans un mode de réalisation, l'unité électronique de contrôle comporte le dispositif de mémorisation de données 4.

Les moyens de commande du dispositif de lecture et d'enregistrement d'impulsions 1 comprennent des moyens matériels et/ou logiciels.

A titre d'exemple nullement limitatif, les moyens matériels peuvent comprendre au moins un microcontrôleur.

Grâce à la présente invention, le procédé de configuration d'un dispositif de lecture et d'enregistrement d'impulsions permet de lire et d'enregistrer des impulsions générées par un compteur au moyen d'un capteur de détection d'impulsions quel que soit le type de consommation à mesurer.

De cette manière, le dispositif de lecture et d'enregistrement d'impulsions comprend un capteur de détection d'impulsions dit universel connecté à un compteur de sorte à compter le nombre d'impulsions émises par le compteur quel que soit le type de consommation à mesurer.

Bien entendu, de nombreuses modifications peuvent être apportées aux exemples de réalisation décrits précédemment sans sortir du cadre de l'invention.

En particulier, la consommation à mesurer peut être de type différente, et par exemple à partir d'impulsions émises par un compteur d'un réseau téléphonique.

## Revendications

1. Procédé de configuration d'un dispositif de lecture et d'enregistrement d'impulsions (1) destiné à effectuer une lecture d'au moins un compteur (2) émettant des impulsions, le compteur (2) étant apte à générer des impulsions pour un type donné de consommation à mesurer, ledit dispositif (1) comprenant au moins un capteur de détection d'impulsions (3) et au moins un dispositif de mémorisation de données (4), le capteur de détection d'impulsions (3) étant connecté au compteur (2), **caractérisé en ce que** ledit procédé comprend au moins :
- une acquisition (E11) d'une donnée relative au type donné de consommation à mesurer, le type donné de consommation à mesurer étant dépendant du compteur (2) ;
- une mémorisation (E15) par un dispositif de mémorisation de données (4) de ladite donnée acquise relative au type donné de consommation à mesurer par l'intermédiaire dudit capteur de détection d'impulsions (3) connecté audit compteur (2).

2. Procédé de configuration d'un dispositif de lecture et d'enregistrement d'impulsions (1) selon la revendication 1, **caractérisé en ce que** la donnée acquise relative au type donné de consommation à mesurer et est distinguée parmi une liste de types de consommation à mesurer.

3. Procédé de configuration d'un dispositif de lecture et d'enregistrement d'impulsions (1) selon la revendication 2, **caractérisé en ce que** la liste de plusieurs types de consommation à mesurer inclut une ou plusieurs des consommations à mesurer suivantes : le gaz, l'électricité, l'énergie thermique ou l'eau.

4. Procédé de configuration d'un dispositif de lecture et d'enregistrement d'impulsions (1) selon l'une quelconque des revendications 1 à 3, **caractérisé en ce que** l'étape d'acquisition (E11) d'une donnée relative au type donné de consommation à mesurer est mise en oeuvre par une saisie par un utilisateur de la consommation à mesurer au travers de moyens de sélection d'un terminal (6) du dispositif de lecture et d'enregistrement d'impulsions (1).

5. Procédé de configuration d'un dispositif de lecture et d'enregistrement d'impulsions (1) selon l'une quelconque des revendications 1 à 4, **caractérisé en ce que** ledit procédé comprend en outre :
- une acquisition (E12) d'une valeur de la consommation à mesurer par l'intermédiaire dudit capteur de détection d'impulsions (3) connecté audit compteur (2) correspondant à une impulsion dudit compteur (2),
- une mémorisation (E15) par ledit dispositif de mémorisation de données (4) de ladite valeur acquise de la consommation à mesurer par l'intermédiaire dudit capteur de détection d'impulsions (3) connecté audit compteur (2) correspondant à une impulsion dudit compteur (2).

6. Procédé de configuration d'un dispositif de lecture et d'enregistrement d'impulsions (1) selon l'une quelconque des revendications 1 à 5, **caractérisé en ce que** ledit procédé comprend :
- une initialisation (E13) d'une valeur de départ dudit dispositif de mémorisation de données (4),
- une mémorisation (E15) par ledit dispositif de mémorisation de données (4) de ladite valeur de départ.

7. Procédé de configuration d'un dispositif de lecture et d'enregistrement d'impulsions (1) selon la revendication 6, **caractérisé en ce que** ladite valeur de départ dudit dispositif de mémorisation de données (4) est équivalente à une valeur affichée par ledit compteur (2).

8. Procédé de configuration d'un dispositif de lecture et d'enregistrement d'impulsions (1) selon l'une quelconque des revendications 1 à 7, **caractérisé en ce que** ledit procédé comprend :
- une transmission de données (E14) entre un terminal (6) et ledit dispositif de mémorisation de données (4) lors de l'acquisition d'une donnée relative au type de consommation à mesurer.

9. Procédé de configuration d'un dispositif de lecture et d'enregistrement d'impulsions (1) selon la revendication 8, **caractérisé en ce que** la transmission de données (E14) est mise en oeuvre à distance par transmission radio.

10. Procédé de commande en fonctionnement d'un dispositif de lecture et d'enregistrement d'impulsions (1), **caractérisé en ce que** ledit procédé comprend une lecture et un enregistrement d'impulsions (E21) émises par au moins un compteur (2), en fonction de la mémorisation (E15) selon le procédé de configuration dudit dispositif de lecture et d'enregistrement d'impulsions conforme à l'une quelconque des revendications 1 à 9, d'une donnée relative au type de consommation à mesurer.

11. Procédé de commande en fonctionnement d'un dispositif de lecture et d'enregistrement d'impulsions (1) selon la revendication 10, **caractérisé en ce que** ledit procédé comprend l'affichage (E23) de la consommation mesurée, en fonction du nombre d'impulsions lues par ledit capteur de détection d'impulsions (3) lors de la lecture et de l'enregistrement d'impulsions (E21) et de ladite valeur acquise de la consommation à mesurer correspondant à une impulsion dudit compteur (2).

12. Dispositif de lecture et d'enregistrement d'impulsions (1) destiné à effectuer une lecture d'au moins un compteur (2) émettant des impulsions, ledit dispositif (1) comprenant au moins un capteur de détection d'impulsions (3) et au moins un dispositif de mémorisation de données (4), **caractérisé en ce que** ledit dispositif (1) comprend des moyens de commande configurés pour mettre en oeuvre ledit procédé de configuration conforme à l'une quelconque des revendications 1 à 9.

13. Dispositif de lecture et d'enregistrement d'impulsions (1) selon la revendication 12, **caractérisé en ce que** ledit dispositif (1) comprend une pluralité de compteurs (2), où lesdits compteurs (2) sont connectés respectivement à un capteur de détection d'impulsions (3) différent.

14. Dispositif de lecture et d'enregistrement d'impulsions (1) selon la revendication 12 ou la revendication 13, **caractérisé en ce que** ledit dispositif (1) comprend un capteur de détection d'impulsions (3) connecté à une pluralité de compteurs (2).

15. Installation comprenant au moins un système consommateur d'énergie et/ou d'eau, **caractérisé en ce qu'**il comprend un dispositif de lecture et d'enregistrement d'impulsions (1) conforme à l'une quelconque des revendications 12 à 14.
